# EUROPEAN PATENT APPLICATION

(11) **EP 2 469 603 A1**
(43) Date of publication of application: **27.06.2012**
(21) Application number: 10290684.9
(22) Date of filing: 27.12.2010
(51) Int. Cl.: H01L 31/0236, H01L 31/18, H01L 31/0224

(54) **Improved method for manufacturing a photovoltaic device comprising a TCO layer**

(71) Applicant: Centre National de la Recherche Scientifique, 75794 Paris Cedex 16 (FR); Ecole Polytechnique, 91128 Palaiseau Cedex (FR); Total S.A., 92078 Paris La Défense Cedex 6 (FR); Excico Group NV, 3500 Hasselt (BE)
(72) Inventor: Roca i Cabarrocas, Pere ,, 91128 Palaiseau Cedex (FR); Prod'homme, Patricia, 92400 Courbevoie (FR); Johnson, Erik ,, 91128 Palaiseau Cedex (FR); Emeraud, Thierry ,, 3500 Hasselt (BE)
(74) Representative: BiiP cvba

(57) **Abstract**

The present invention is directed to a method for fabricating a photovoltaic device, comprising depositing a transparent conductive oxide (TCO) layer on a substrate, exposing the TCO layer to laser irradiation using a set of irradiation parameters, and exposing the laser irradiated TCO layer to an etching process using a set of etching parameters, characterized in that the irradiation parameters and the etching parameters are selected such that the haze% of the TCO layer increases compared to the as deposited TCO layer.
Additionally, the present invention is directed to a TCO layer having a haze% of at least 20% for an incident light wavelength contained in the range between 350 and 1300 nm.
Further the present invention is directed to a photovoltaic device comprising such TCO-layer.

## Description

### FIELD OF THE INVENTION

The present invention relates to a method for fabricating a photovoltaic device, comprising depositing a transparent conductive oxide (TCO) layer on a substrate, annealing the TCO layer by laser irradiation, and exposing the TCO layer to an etching process. Further the present invention is directed to a photovoltaic device comprising such TCO layer.

### BACKGROUND OF THE INVENTION

As commonly known, the more incident light is trapped, the better the quantum efficiency (QE) and short circuit current density (Jsc) of a photovoltaic (PV) cell. Therefore, techniques for improving light trapping are used to enhance the absorption of incident light in photovoltaic active layers i.e. the layers where the electrical carriers are generated, and consequently the short-circuit current in photovoltaic cells. Such techniques are mostly important for cells using thin PV active layers (less than 2µm in thickness) or active material weakly absorbing the incident solar light

One of these techniques consists of inducing haze or light scattering at the interfaces of the photovoltaic device. Therefore typically a substrate with a textured surface is utilized to generate roughness at the interfaces. When light photons hit the rough surface of a PV active layer at a given incident angle, higher angles of refraction are generated inside the PV active layer than the angle of refraction that can be classically calculated on a planar interface with the incident angle and material's refractive index. Hence, photons will travel a longer distance in the PV active layer, increasing the amount of absorbed light and generated carriers. Also on rough surfaces, much fewer photons are reflected off the surface hence more photons are collected in the active layer or reflected back towards it after a double pass inside the active layer, increasing light scattering and trapping in the photovoltaic device. Transparent conductive oxide (TCO) layers, either deposited in on top of an absorbing layer, either deposited on a glass or polymer substrate, or deposited on top of a metal layer or a metallic substrate as part of an internal reflector assembly, are used because of their high conductivity, low optical absorption and high scattering properties.

As described in Chimdindu U. Nebo's Thesis, TUDelft, September 2009, TCO layers for photovoltaic cells can be provided with native or post-fabricated surface roughness in order to induce haze and to scatter incident light more efficiently.

A first problem when increasing the TCO surface roughness through texturing by means of wet chemical etching after deposition as described in DE19713215, is that for a given TCO thickness, sufficient roughening after deposition requires sufficient etching, resulting in significant wasted material that will in turn result in decreased electrical conductivity.. In additionto achieve a given TCO roughness and electrical conductivity with another deposition technique, a thicker TCO film may be grown but such thicker layer will absorb more light (lost for the PV device) and will require longer deposition times. Finally, for this technique of generating a textured TCO layer, the initial layer that result in an optimal texture must be deposited on a substrate heated to temperatures between 250 and 375°C.

A second more general problem arising when increasing the TCO surface roughness is the possibility for a poor condition of the TCO surface for subsequent thin film deposition. For example in a configuration where a thin microcrystalline silicon absorber layer is deposited on the TCO, overly sharp angles in the textured profile of the TCO result in insufficient silicon layer quality and/or device defects. Pinholes or shorts may be generated at the silicon-TCO interface due to sharp peaks, and poor material resulting from unfavorable material growth conditions may result from the presence of sharp valleys, both resulting in decreased photovoltaic cell performance [R. E. I. Schropp, H. Li, J. K. Rath and C.H.M. van der Werf Surf. Interface Anal. 2008, 40, 970-973].

Another solution proposed by Dong-Won Kang et al. (Highly Transparent and High Haze ZnO:Al Film for Front TCO of a-Si:H and µc-Si:H Solar Cells by Controlling Oxygen Flow) may be to modify the TCO morphology by utilizing a two step process for the deposition the TCO, consisting of the deposition of a seed layer, then the bulk layer. These steps are then followed by a subsequent texturizing step. It is clear this results in rather complex and expensive processing.

Considering the above, it is a first object of the present invention to provide a TCO layer having sufficient surface quality for providing increased scattering or light trapping properties, a photovoltaic device comprising such TCO layer, and a method for manufacturing such photovoltaic device.

Additionally, it is a second object of the present invention to provide a TCO layer with a surface condition suitable for subsequent high-quality layer deposition while keeping increased scattering or light trapping properties, a photovoltaic device comprising such TCO layer, and a method for manufacturing such photovoltaic device.

It is a third object of the present invention to provide a simpler and more cost-effective method for providing a TCO layer fulfilling the above requirements from TCO deposited at low or even room temperature

It is a fourth object of the present invention to provide simultaneously a method for providing a TCO layer with enhanced electrical conductivity performance from TCO deposited at low or even room temperature.

Further, it is an object of the present invention to provide simultaneously a method for providing a TCO layer with enhanced optical transparency performance from TCO deposited at low or even room temperature.

Further, it is an object of the present invention to provide a TCO having sufficient surface quality to decrease electrical shorts occurrence in thin film photovoltaic devices, particularly thin film photovoltaic devices with absorbing layer thickness less than 2µm like those used in single, and multi-junction amorphous silicon solar cells and in tandem tandem solar cell combining amorphous and microcrystalline silicon. Another object of the present invention is to provide a photovoltaic device with improved performance and efficiency.

The present invention meets the above objects by exposing the deposited TCO layer to laser irradiation and a subsequent etching process using a set of irradiation parameters and a set of etching parameters selected such that the haze% of the TCO layer increases compared to the haze% of the as deposited TCO layer.

### SUMMARY OF THE INVENTION

The present invention is directed to a method for fabricating a photovoltaic device, comprising depositing a transparent conductive oxide (TCO) layer on a substrate, exposing the TCO layer to laser irradiation using a set of irradiation parameters, and exposing the laser irradiated TCO layer to an etching process using a set of etching parameters,
characterized in that the irradiation parameters and the etching parameters are selected such that the haze% of the TCO layer increases compared to the haze% of the as deposited TCO layer.

Additionally, the present invention is directed to a TCO layer having a haze% of at least 20% for an incident light wavelength contained in the range between 350 and 1300 nm.

Further the present invention is directed to a photovoltaic device comprising such TCO-layer.

### BRIEF DESCRIPTION OF THE DRAWINGS

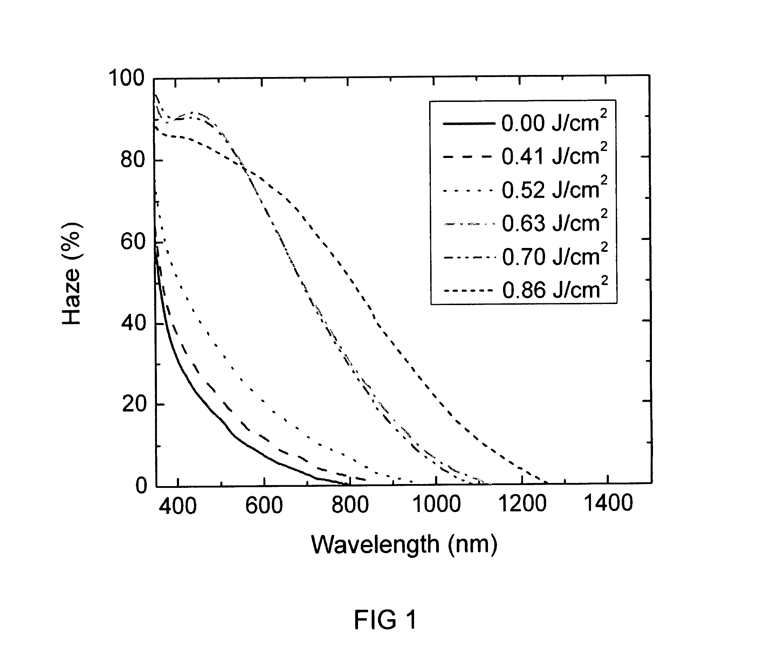

FIG 1 is an illustration of haze% measured on a ZnO:Al layer after pulsed laser annealing and wet chemical etching as described in the example.

### DESCRIPTION OF THE INVENTION

According to a first embodiment of the present invention, a method for fabricating a photovoltaic device is provided, comprising depositing a transparent conductive oxide (TCO) layer on a substrate, exposing the TCO layer to laser irradiation using a set of irradiation parameters, and exposing the laser irradiated TCO layer to an etching process using a set of etching parameters,
characterized in that the irradiation parameters and the etching parameters are selected such that the haze% of the TCO layer increases compared to the haze% of the as deposited TCO layer.

As known by a person skilled in the art, in the field of flexible displays laser annealing is used for annealing TCO layers subsequent to low thermal budget deposition. In that case the annealing step aims to increase the optical transmission in the visible range and to decrease the haze%, as illustrated in Laser-Crystallized High Quality ITO on Plastic Substrates for Flexible Displays (Wonsuk Chung et al). Surprisingly, it has now been found that when exposing the deposited TCO laser to laser annealing using the appropriate irradiation parameters and then exposing the irradiated TCO to an etching process using the appropriate etching parameters, the haze% of the TCO layer can be significantly increased compared to the as deposited TCO.

In the context of the present invention, haze percentage (haze%) is the percentage of incident transmitted light scattering out of specular direction. In particular haze% for transmitted light is of utmost importance since this parameter influences the length of the light path in the PV active layer of the photovoltaic device, which on its turncontributes to a higher probability in generating photo-carriers in the PV active layer.

In general, haze% is dependent on refractive indices, roughness of the surface, incident angle and wavelength of the light photons. Without being bound by any theory it is believed that by laser annealing with the appropriate irradiation parameters, the grain morphology and distribution as well as the grain boundaries properties in the bulk TCO layer are modified. When combining the laser annealing with a texturing process using appropriate etching parameters, the haze% of the TCO layer is significantly increased compared to the as deposited TCO layer, resulting in improved scattering or light trapping properties, while keeping sufficient surface layer quality. Consequently, haze% increase may result in higher photovoltaic device performance and efficiency.

The haze% of the TCO layer may be increased compared to the as deposited TCO layer with at least 15%, at least 30%, at least 50%, or at least 80% in the visible light wavelength range. As illustrated in FIG 1, a value above 20%, or even above 75% may be reached at 600nm, and above 30% or even above 50% at 800nm.

Another advantage is that the present invention enables manufacturing a TCO layer with increased light trapping and surface quality properties from TCO deposited at low or even at room temperature, such that underlying layers or an underlying fragile substrate will not be exposed to excessive thermal budget which may degrade those underlying layers or fragile substrate.

In an embodiment according to the present invention, a method for providing a photovoltaic device is provided wherein the irradiation parameters and the etching parameters may be elected such that additionally the optical absorption of the TCO layer decreases compared to the as-deposited TCO layer in a wavelength range from 350 nm to 1300 nm.

In another embodiment according to the present invention, a method for providing a photovoltaic device is provided wherein the irradiation parameters are selected such that additionally the conductivity of the TCO layer increases compared to the as-deposited TCO layer.

In accordance with the present invention, the etching process may comprise exposure to an aqueous etchant solution wherein the etching parameters comprise etching temperature, etching time, etchant concentration, or a combination thereof.

Such aqueous etchant solution may comprise dilute hydrochloric acid, dilute hydrobromic acid, dilute hydrofluoric acid, a solution of potassium chloride, or a mixture thereof.

The etchant concentration may be between 0.03 and 4 volume percent, between 0.1 and 3, between 0.2 and 2, or between 0.5 and 1 volume percent.

The etching temperature may be between 10 degrees Celsius and 90 degrees Celsius, between 15 and 50 degrees Celsius, or preferably at room temperature.

The etching time may be between 5 seconds and 120 seconds, between 20 and 120 seconds, or between 40 and 120 seconds.

Examples of aqueous solution etch processes used in a method according to the present invention may be:
- etching of flat, aluminium-doped zinc-oxide (ZnO:Al) thin films using a dilute hydrochloric acid aqueous solution (0.5 volume percent) performed at room temperature for an etching time of approximately 40 seconds, resulting in an etch rate of 6nm/s.
- etching of flat, aluminium-doped zinc-oxide (ZnO:Al) thin films using a dilute hydrofluoric acid aqueous solution, (1 volume percent) performed at room temperature for an etching time of approximately 120 seconds.
- electrochemical anodic etching of flat, aluminium-doped zinc-oxide (ZnO:Al) thin films using a potassium chloride aqueous solution, performed at room temperature.

Alternatively to exposure to an aqueous etchant solution, the etching process may also comprise a plasma-based reactive etching process wherein the etching parameters comprise gas mixture, gas flows, etching time, pressure, RF bias power, or a combination thereof. Examples of such plasma-based reactive etching process may be inductively coupled plasma etching or electron cyclotron resonance plasma etching.

Such gas mixture may comprise methane, chlorine, boron chloride, carbon tetrafluoride, or a mixture thereof, while the etching time may be between 30 seconds and 20 minutes.

Examples of plasma-based reactive etching processes used in a method according to the present invention may be:
- inductively coupled plasma to etch flat, aluminum-doped zinc-oxide (ZnO:Al) thin films, using a gas mixture of methane/hydrogen/argon (CH4/H2/Ar) at a temperature of 25°C and with an RF power of 200W, resulting in an etch rate of 200nm/min.
- inductively coupled plasma to etch flat, aluminum-doped zinc-oxide (ZnO:Al) thin films, using a gas mixture of boron chloride/methane/hydrogen (BCl3:CH4:H2 = X:3:1 where X can take on values between 0 and 4), at room temperature, with an RF power of 1200 W, a process pressure of 5 mTorr, and a substrate temperature of 20°C, resulting in an etch rate of approximately 100-300 nm/min.
- electron cyclotron resonance plasma to etch flat, aluminum-doped zinc-oxide (ZnO:Al) thin films using a gas mixture of CH4 and carbon tetrafluoride (CF4) and an injected microwave power of 80W, resulting in an etch rate of approximately 10-40 nm/min.

In accordance with the present invention, the laser irradiation may be pulsed and may be in the range of 100 ns to 1000 ns, or between 100 ns and 600 ns, between 100 ns and 450 ns, or preferably between 130 and 300 nanoseconds.

Further in accordance with the present invention, the laser irradiation may expose the TCO layer to a temperature at which it undergoes profound structural modifications and possibly up to the melting temperature of the TCO.

In an embodiment in accordance with the present invention, the irradiation may be pulsed wherein with each pulse a portion of at least 1 cm², at least 5 cm², at least 10 cm², at least 20 cm², or at least 40cm² may be irradiated, which makes the present invention suitable for industrial manufacturing of thin film photovoltaic devices on large substrates at high throughputs.

The laser may be any laser whose wavelength, energy and pulse duration is adapted to the process, such as solid state lasers, gas lasers or excimer lasers. Preferably, the laser may be an excimer laser, more preferably a xenon chloride excimer laser. The wavelength of the laser may be in the range from 190 nm to 600 nm, 190 nm to 550 nm, or 190 nm to 450 nm due to the high energy absorption of TCO at those wavelengths, and preferably 308 nm.

The laser energy may be in the range of 1 Joules to 25 Jouies. in order to achieve these energies, the laser discharge volume is optimized to typically 10 cm (inter electrodes spacing) x 7 to 10 cm (discharge width) x 100 to 200 cm (discharge length).

In an embodiment of the present invention, the laser may be adapted to produce a projected laser beam with an energy density between 0 and 10 J/cm², between 0 and 5 J/cm², and preferably between 0 and 2 J/cm², and even more preferably between 0,5 and 0,8 J/cm².

In a preferred embodiment, the laser may be an excimer laser adapted to produce a large area output beam of more than 60 cm², more than 80 cm², preferably 100 cm², having a projected beam spot typically of at least 1 cm², at least 5 cm², and up to 20 or even 40 cm² with an energy density between 0.1 and 10 J/cm².

In a preferred embodiment of the present invention, the laser may have a wavelength of 308 nm, a pulse duration between 100 and 200 nanoseconds and a projected beam energy density between 0.1 and 10 J/cm².

The TCO material may be any TCO material used in photovoltaics, such as for example fluorine doped tin oxide (Sn02:F), indium doped tin oxide, intrinsic zinc oxide (i-ZnO), aluminum doped zinc oxide (Al:ZnO or AZO), boron doped zinc oxide, tin doped indium oxide (ITO), titanium doped indium oxide (ITiO), zinc doped indium oxide (IZO), zinc magnesium oxide (ZnMgO), gallium indium oxide (GalnO3), cadmium oxide (Cd:O), cadmium (indium) zinc oxide (Cd₁₊ₓIn₂₋₂ₓSnₓO4 (from CdIn2O4 to Cd2SnO4)), or titanium oxide (Ti02) including niobium-doped or tantalum-doped Ti02.

These TCO materials may be used in either amorphous or in microcrystalline film structure, depending on deposition technique and process conditions. Preferably low temperature deposition is used. These materials may also be dispensed as bound TCO particles in a paste or a solution by various deposition technologies, such as for example inkjet printing or screen printing or spraying.

The substrate may be any kind of substrate used in photovoltaics. Examples are glass, quartz, polymer (rigid or flexible) such as for instance polyethylene terephtalate (PET) or polyethylene naphtalate (PEN), or any semiconductor material (bulk or thin film) suitable for photovoltaic applications such as for example mono crystalline silicon, undoped silicon or doped silicon, polycrystalline silicon, implanted silicon, silicon carbide, amorphous silicon, microcrystalline silicon, silicon germanium, III-V compound semiconductors such as gallium arsenide, gallium aluminum arsenide, gallium nitride, II-VI compound semiconductors like cadmium telluride, copper indium diselenide (CuInSe2), copper indium sulfide (CuInS2) or copper indium gallium diselenide (Cu(In,Ga)Se2) and the like, or multi-junction semiconductor stacks and the like, or even chalcogenide or organic semiconductor materials.

In an additional embodiment in accordance with the present invention, a TCO layer may be provided having a haze% of at least 15%, at least 30% or at least 80% in the visible light wavelength range. Such layer may even have a haze% above 65% at 600nm, and between 30% and 50% at 800nm.

As an example, a TCO layer in accordance with the present invention may be used both in superstrate and substrate configuration PV cells, in thin film photovoltaic devices based on amorphous silicon, microcrystalline silicon, or both combined in a tandem cell design, or on top of a copper indium diselenide (CIS) or copper indium gallium diselenide (CIGS) or copper indium sulfide (CuInS2) or copper-indium-gallium-sulphur-selenium (CIG(S,Se)2) absorbing layer, or on top of a metal layer or metal substrate as part of a light reflector assembly.

Further, in a final embodiment in accordance with the present invention, a photovoltaic device is provided comprising a TCO-layer as described in the above embodiments. Such photovoltaic devices may be for example standard monocrystalline and multi-crystalline P-N junction solar cells using either N-Type or P-Type silicon substrates, epitaxial silicon solar cells grown on different types of substrates, hetero-junction solar cells, back contact or rear contact solar cells (RCC, BCC) and interdigitated back contact cells (IBC), organic photovoltaic solar cell or dye-sensitized solar cells (DSSC, DSC or DYSC).

### EXAMPLE:

A particularly effective process combination that has been determined using the elements described in this text is the combination of the following process steps:
deposition of the ZnO:Al film by reactive sputtering of a ceramic ZnO:Al target through RF excitation at room temperature under conditions leading to a film with a sheet conductance of 0.1 Siemens per square, followed by a pulsed laser annealing step at a fluence of 0.7J/cm² over a pulse duration of more than 130 ns using a high energy excimer laser source emitting at 308 nm. The final process step before cell deposition is a wet-chemical etch step consisting of a 20s dip in a 0.5 volume percent aqueous solution of hydrochloric acid. This set of process conditions results in a transparent oxide layer with a sheet conductance of more than 0,083 Siemens per square, and a haze value of 30% at 800nm as illustrated in FIG 1.

## Claims

1. A method for fabricating a photovoltaic device, comprising depositing a transparent conductive oxide (TCO) layer on a substrate, exposing the TCO layer to laser irradiation using a set of irradiation parameters, and exposing the laser irradiated TCO layer to an etching process using a set of etching parameters,
**characterized in that** the irradiation parameters and the etching parameters are selected such that the haze% of the TCO layer increases compared to the haze% of the as deposited TCO layer.

2. A method according to claim 1, wherein the irradiation parameters and the etching parameters are selected such that additionally the optical absorption of the TCO layer decreases compared to the optical absorption of the as-deposited TCO layer in a wavelength range from 350nm to 1300nm.

3. A method according to claim 1 or 2, wherein the irradiation parameters are selected such that additionally the conductivity of the TCO layer increases compared to the as-deposited TCO layer.

4. A method according to claims 1 to 3 wherein the etching process comprises exposure to an aqueous etchant solution and wherein the etching parameters comprise etching temperature, etching time, etchant concentration, or a combination thereof.

5. A method according to claim 4, wherein the aqueous etchant solution comprises dilute hydrochloric acid, dilute hydrobromic acid, dilute hydrofluoric acid, a solution of potassium chloride, or a mixture thereof.

6. A method according to claims 4 to 5, wherein the etchant concentration is between 0.03 - 4 percent volume.

7. A method according to claims 4 to 6, wherein the etching temperature is between 10 degrees Celsius and 90 degrees Celsius.

8. A method according to claims 4 to 7, wherein the etching time is between 5 seconds and 120 seconds.

9. A method according to claims 1 to 3 wherein the etching process comprises a plasma-based reactive etching process and wherein the etching parameters comprise gas mixture, gas flows, etching time, pressure, RF bias power, or a combination thereof.

10. A method according to claim 9, wherein the gas mixture comprises methane, chlorine, boron chloride, carbon tetrafluoride, or a mixture thereof.

11. A method according to claims 9 to 10, wherein the etching time is between 30 seconds and 20 minutes.

12. A method according to any of the above, wherein the laser irradiation is pulsed and has a pulse duration from 130 to 300 nanoseconds.

13. A method according to any of the above, wherein the laser irradiation has a beam energy density between 0 and 2 Joule/cm².

14. A method according to any of the above, wherein the irradiation is performed by a laser with an output wavelength less than 450nm.

15. A method according to any of the above, wherein the irradiation is performed by an excimer laser.

16. A method according to any of the above, wherein depositing the TCO layer comprises low-temperature deposition, magnetron sputtering, inkjet printing, screen printing, solution spraying, atmospheric pressure chemical vapor deposition (CVD), low-pressure CVD, metallo-organic CVD, chemical solution deposition (for instance sol-gel), or electro-chemical deposition.

17. A method according to any of the above, wherein the TCO layer comprises doped zinc oxide

18. A method according to claim 17, wherein the zinc oxide is doped with aluminum or boron.

19. A method according to any of claims 1 to 16, wherein the TCO layer comprises doped tin oxide

20. A method according to claim 19, wherein the tin oxide is doped with indium or fluorine.

21. A TCO layer produced according to any of the above claims and having a haze% of at least 20% for an incident light wavelength contained in the range between 350 and 1300 nm.

22. A photovoltaic device comprising a TCO-layer according to claim 21.
